Europäisches Patentamt

European Patent Office

Office européen des brevets

(11) Publication number: **0 074 804**
**B1**

## (12) EUROPEAN PATENT SPECIFICATION

(45) Date of publication of patent specification: **02.09.87**

(21) Application number: **82304745.1**

(22) Date of filing: **09.09.82**

(51) Int. Cl.⁴: **H 01 L 23/52**

(54) Semiconductor integrated circuit comprising a semiconductor substrate and interconnecting layers.

(30) Priority: **10.09.81 JP 142941/81**

(43) Date of publication of application:
**23.03.83 Bulletin 83/12**

(45) Publication of the grant of the patent:
**02.09.87 Bulletin 87/36**

(84) Designated Contracting States:
**DE FR GB**

(56) References cited:
**EP-A-0 021 661**
**US-A-3 983 619**

(73) Proprietor: **FUJITSU LIMITED**
**1015, Kamikodanaka Nakahara-ku**
**Kawasaki-shi Kanagawa 211 (JP)**

(72) Inventor: **Tanizawa, Tetsu**
**Dai 2 Yurigaoka-ryo 2-7-5 Chiyogaoka Asao-ku**
**Kawasaki-shi Kanagawa 215 (JP)**
Inventor: **Omichi, Hitoshi**
**Dai 2 Taihei-so 203 Shukugawara Tama-ku**
**Kawasaki-shi Kanagawa 214 (JP)**
Inventor: **Mitono, Yoshiharu**
**1-14-12 Sakuragaoka Setagaya-ku**
**Tokyo 156 (JP)**

(74) Representative: **George, Sidney Arthur et al**
**GILL JENNINGS & EVERY 53-64 Chancery Lane**
**London WC2A 1HN (GB)**

Courier Press, Leamington Spa, England.

## Description

This invention relates to a semiconductor integrated circuit (IC), and particularly to an IC of a so-called semi-custom type in which prefabricated circuit elements are suitably wired during the IC production process by using, for example, metal sputtering, in accordance with the user's needs.

One type of such an IC is a master slice gate array large-scale intergration (LSI) circuit, comprising a bulk including a plurality of basic cells, each cell having at least a transistor and resistance elements, arranged in a plurality of arrays. The wiring inside each basic cell and between the basic cells can be designed automatically with the aid of a computer to produce many varieties of products from one type of bulk. This is particularly suitable for small lot production of diverse items.

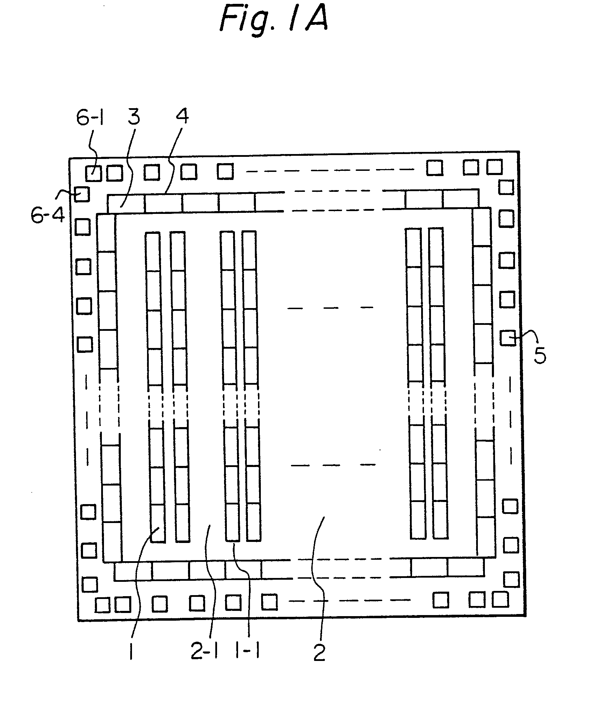

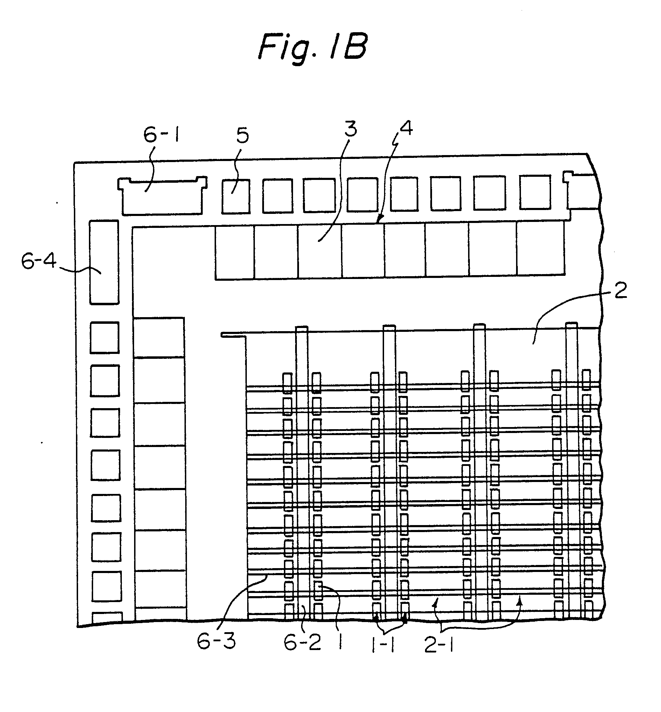

In Fig. 1A of the accompanying drawings, one chip of a typical gate array LSI circuit is illustrated, and Fig. 1B shows an enlarged view of one corner of the LSI chip of Fig. 1A. The LSI chip of Fig. 1A comprises an inner cell area 2 having an array 1-1 of inner cells 1, an automatic wiring area 2-1 for connecting inner cells 1, and an I/O (input/output) cell area 4 having a plurality of I/O buffer cells 3 serving as an electrical interface between the inner cells and the external circuit. At the corners of the LSI chip, as shown in Fig. 1B, voltage source pads 6-1 and ground pads 6-4 are provided and, at the sides of the LSI chip, signal line pads 5 are each connected to one of the I/O cells, which are arranged in a row. As shown in Fig. 1B, a plurality of voltage source lines 6-2 are arranged in one wiring layer above the inner cell area 2, each of the voltage source lines 6-2 runs across the area 2 in a lengthwise direction, and a plurality of ground lines 6-3 are arranged in another wiring layer above the inner cell area 2, each of the ground lines 6-3 running across the area 2 in the lateral direction.

Each of the inner cells 1 and each of the I/O buffer cells 3 consists of one basic cell which comprises circuit elements such as transistors, diodes, resistors, and capacitors. By appropriately interconnecting the circuit elements inside each of the basic cells and between two basic cells, various kinds of logic functions can be accomplished.

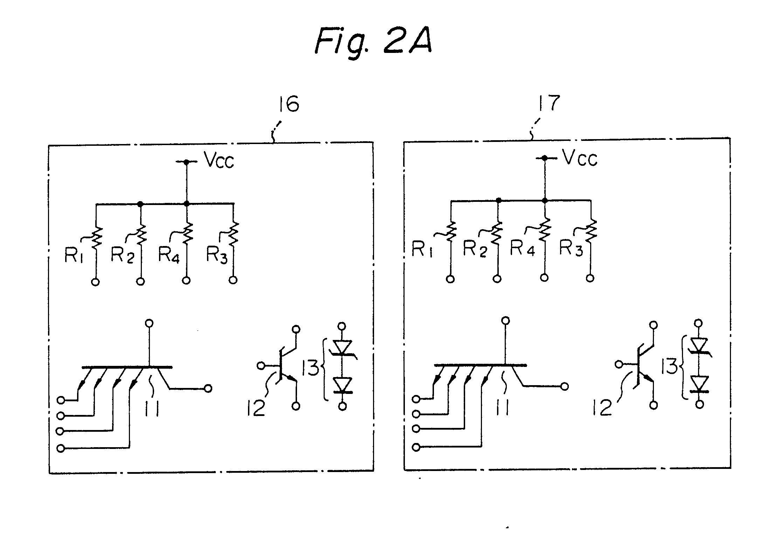

One example of the construction of the above-mentioned basic cells is illustrated in Fig. 2A. In Fig. 2A, two basic cells 16 and 17 are shown. The basic cells 16 and 17 each comprise resistors $R_1$ through $R_4$, a multi-emitter transistor 11, a Schottky transistor 12, and a diode 13. These circuit elements of the basic cells are enough to construct basic logic circuits necessary to construct a logic system as a whole in an LSI chip. The bulk in the LSI chip used for master structure is formed by arranging a large number of basic cells, each of which comprises such circuit elements as shown in Fig. 2A in array fashion.

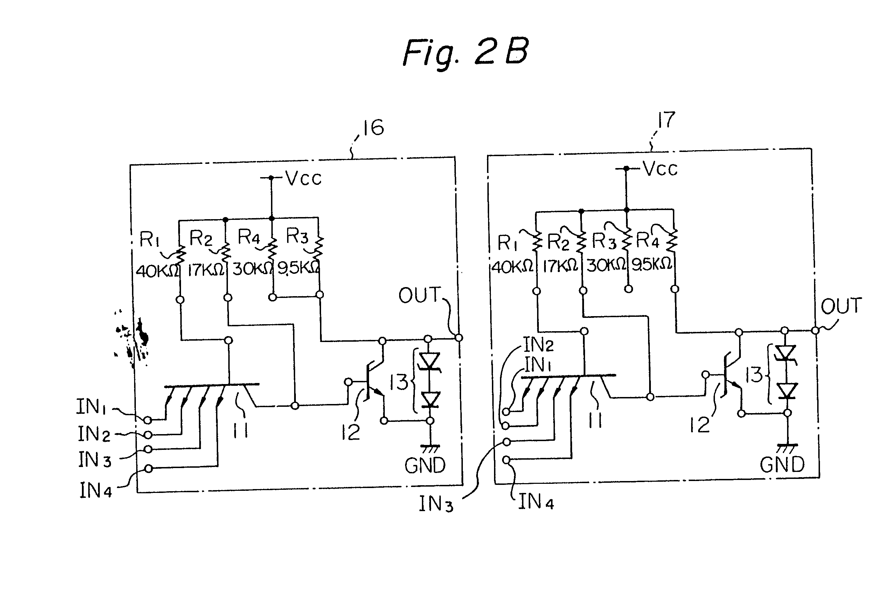

In Fig. 2B, two of four input TTL circuits formed by using the basic cells 16 and 17, respectively, and interconnecting the circuit elements of the basic cells are illustrated. In each of the basic cells 16 and 17 of Fig. 2B, the resistor $R_1$ (40 kΩ) is connected to the base of the multi-emitter transistor 11, the resistor $R_2$ (17 kΩ) is connected to the collector of the multi-emitter transistor 11 and the base of the Schottky transistor 12, the resistor $R_4$ (30 kΩ) is connected to the collector of the Schottky transistor 12 and the anode of the diode 13, and the base of the Schottky transistor 12 and the cathode of the diode 13 are connected to the ground. In the basic cell 16, the resistor $R_3$ (30 kΩ) is connected in parallel with the resistor $R_4$ in order to increase pull-up of the output. The emitters of the multi-emitter transistor 11 are connected to the input terminals $IN_1$, $IN_2$, $IN_3$ and $IN_4$, respectively, and the collector of the Schottky transistor 12 is connected to the output terminal OUT.

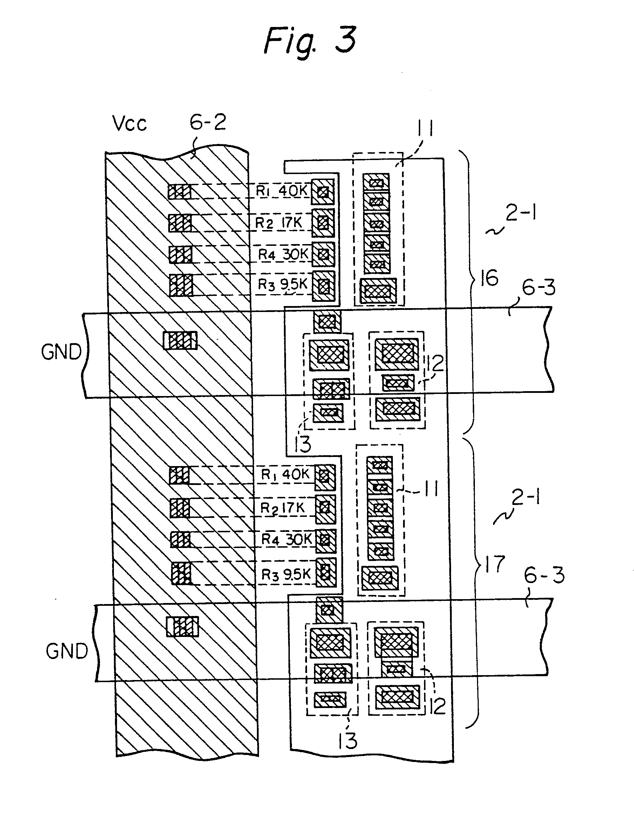

Figure 3 illustrates the master structure of the LSI chip, including the basic cells 16 and 17 of Fig. 2A, voltage source lines 6-2, and ground lines 6-3. The wirings connecting the circuit elements inside the basic cells and between the basic cells have not yet been formed in the LSI chip of Fig. 3. In the LSI chip of Fig. 3, as wiring layers above the bulk, there is a first wiring layer including mainly Y-direction wiring lines and a second wiring layer including mainly X-direction wiring lines. In Fig. 3, the wiring patterns of the first wiring layer are shown with hatching, and the wiring patterns of the second wiring layer are shown without hatching. The pattern of the voltage source lines 6-2 is formed in the first wiring layer, and the pattern of the ground lines 6-3 is formed in the second wiring layer. Though the basic cells are arranged along both sides of the voltage source lines 6-2, only the two basic cells 16 and 17 on the right side of the voltage source lines 6-3 are shown in Fig. 3. The area where the basic cells are not formed is the automatic wiring area (channel area) 2-1 in which the basic cells are connected. The wiring patterns for the connection between the basic cells are formed in the areas of the first and second wiring layers where the voltage source lines 6-2 and the ground lines 6-3 are not formed.

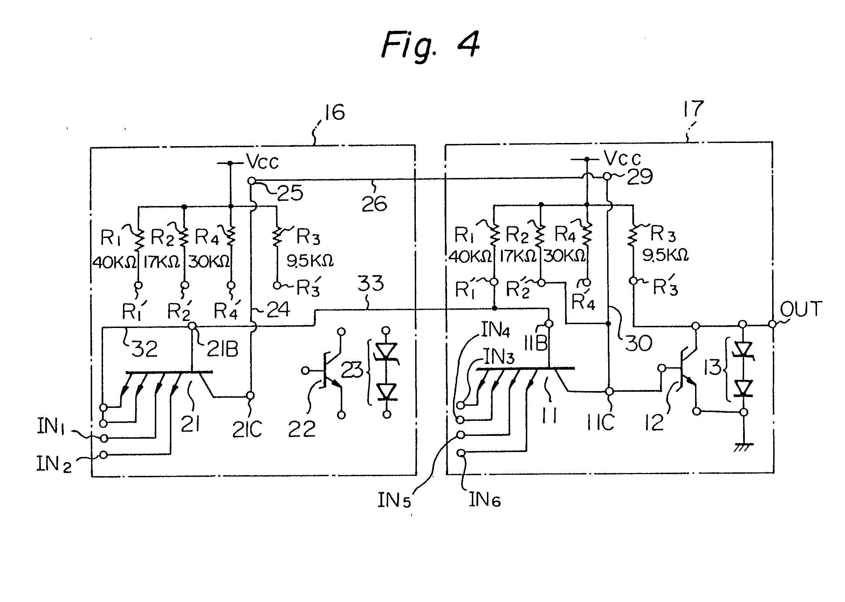

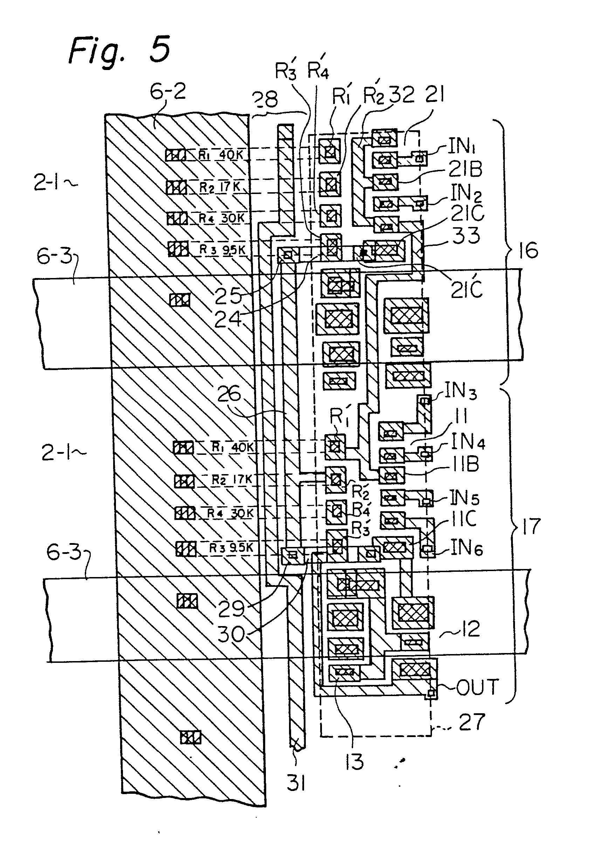

In the LSI chip of Fig. 1A, a macro-cell having one logic function may be constructed by using two or more basic cells and connecting them in the predetermined wiring pattern. For example, a transistor-transistor logic (TTL) circuit having 6 inputs can be constructed by using two basic cells, as shown in Fig. 4 and Fig. 5. Figure 4 illustrates the circuit diagram of the above-mentioned TTL circuit, and Fig. 5 illustrates its wiring pattern.

The 6-input TTL circuit of Fig. 4 is constructed by the multi-emitter transistor 11 of the basic cell 16 and by the multi-emitter transistor 21, the Schottky transistor 12, the diode 13, and the resistors $R_1$, $R_2$, and $R_3$ of the basic cell 17. Two inputs $IN_1$ and $IN_2$ of the multi-emitter transistor 21 of the basic cell 16 and four inputs $IN_3$, $IN_4$, $IN_5$, and $IN_6$ of the multi-emitter transistor 11 of the basic cell 17 are used as six inputs of the TTL circuit.

The connection of the basic cells 16 and 17 shown in Fig. 4 is accomplished by the wiring pattern of Fig. 5. In the pattern of Fig. 5, the bases of the multi-emitter transistors 11 and 21 are connected by the wiring line 33 in the first wiring layer, and two emitters $21E_1$ and $21E_2$ and the base 21B of the multi-emitter transistor 21 are connected by the wiring line 32 in the first wiring layer. These wiring lines 32 and 33 are formed by using the space of the area above the basic cells. However, the collectors 21C and 11C of the multi-emitter transistors 21 and 11 cannot be connected by using the space of the area above the basic cells.

Thus, the connection between the collectors 21C and 11C of the multi-emitter transistors 21 and 11 is accomplished by using the wiring area 28 for the formation of a macro-cell outside the basic cell area in the first wiring layer. That is, the collector 21C is connected to the wiring line 26 in the wiring area 28 in the first wiring layer through the wiring line 24 in the second wiring layer, and the collector 11C is also connected to the wiring line 26 through the wiring line 30 in the second wiring layer. The wiring lines 24 and 30 in the second wiring layer are connected to the wiring lines in the first wiring layer via through holes 21C', 11C', 25, and 29.

In the macro-cell formed in the above-mentioned fashion, as described above, it is necessary to form the wiring line 26 in the wiring area 28 so as to form a macro-cell in order to connect the collector 21C of the multi-emitter transistor 21 to the collector 11C of the multi-emitter transistor 11. Accordingly, the wiring space in the wiring area 28 for the formation of a macro-cell is decreased so that only one wiring line 31 can be formed in the wiring area 28, as shown in Fig. 5. Further, since the wiring lines 24 and 30 in the second wiring layer are formed in the wiring area 27 inside the macro cell area, the freedom of the wiring layout in the macro cell area is decreased. Accordingly, the wiring route may be a roundabout route.

Furthermore, in the macro cell of Fig. 5, since the resistor $R_2$ of the basic cell 17 is connected not only to the collector 11C of the transistor 11 in the basic cell 17 but also to the collector 21C of the transistor 21 in the basic cell 16, the current path from the resistor $R_2$ of the basic cell 17 to the collector 21C of the transistor 21 is substantially longer than the current path from the resistor $R_2$ of the basic cell 17 to the collector 11C of the transistor 11. Accordingly, the current distribution between the basic cells 16 and 17 may be unequal. Such inequality of the current distribution tends to decrease the current margin of the semiconductor device.

In EP—A—21 661 there is described a large-scale integrated circuit device manufactured by using the master slice technique. That device comprises a semiconductor substrate on which basic cells are formed, the basic cells comprising circuit elements including transistors and resistors. Macro cells are formed, by interconnecting groups of the basic cells, to provide predetermined logic functions. Wiring layers are provided to interconnect the elements in the basic cells and to form macro cell connections.

An object of the present invention is to provide an improved semiconductor integrated circuit device.

According to one aspect of the invention, there is provided a semiconductor integrated circuit device comprising a semiconductor substrate; a plurality of voltage source line patterns formed on the semiconductor substrate; a plurality of basic cells formed on the semiconductor substrate together with the voltage source line patterns; groups of mutually parallel resistors formed between the source lines and the basic cells; a plurality of electrodes formed at one end of respective resistors, and connected to a plurality of input transistors formed in the basic cells; a plurality of input transistor electrodes formed in the basic cells; wiring means formed between the source lines and the basic cells; a macro-cell portion comprising a plurality of the basic cells and having a predetermined logic function, the macro-cell being formed by interconnecting resistors belonging to the respective basic cells and by interconnecting input transistors belonging to the basic cells; characterised in that each of the resistors of a group has a resistance value which is an integral multiple of the value of each lower value resistor in the group; and in that a plurality of wiring patterns is formed on the same layer as the input transistor electrodes and the resistor electrodes, for interconnecting one of the transistor electrodes and one of the resistor electrodes in the first basic cell, for interconnecting one of the resistor electrodes of the first basic cell and one of the resistor electrodes of the second basic cell, and for interconnecting one of the resistor electrodes and one of the transistor electrodes of the second basic cell.

According to another aspect of the invention there is provided a semiconductor integrated circuit device, comprising an array of basic cells each including transistors and resistors, formed on the surface of a semiconductor substrate and having transistor electrodes and resistor electrodes, respectively, formed in a wiring layer; and at least one macro-cell formed by interconnecting a plurality of basic cells to provide a predetermined logic function; characterised in that a group of resistors in each of the basic cells is so formed that each of the resistors in the group has a value such that the ratio of that value to the value of each lower-value resistor in the group has an integer value; in that resistance means in the logic circuit of the macro-cell is formed by interconnecting at least two resistors belonging to different basic cells of the macro-cell; and in that wiring patterns are formed in the same wiring layer as the transistor electrodes and the resistor electrodes for interconnecting the electrodes of said resistors of said different basic cells, and for interconnecting transistor electrodes and resistor electrodes within each basic cell.

One embodiment of the present invention will now be described, by way of example, with reference to the accompanying drawings, in which:

Fig. 1A is a plan view of a typical gate array integrated circuit;

Fig. 1B is an enlarged plan view of one corner of the IC shown in Fig. 1A;

Fig. 2A is a circuit diagram of two unconnected basic cells in the IC;

Fig. 2B is a circuit diagram of a TTL circuit formed by connecting the basic cells of Fig. 2A;

Fig. 3 is a plan view of one portion of an IC on which the circuit elements of the basic cells of Fig. 2A are formed;

Fig. 4 is a circuit diagram of a prior art 6-input TTL circuit;

Fig. 5 is a plan view of one portion of an IC on which the TTL circuit of Fig. 4 is formed;

Fig. 6 is a circuit diagram of a 6-input TTL circuit according to the present invention; and

Fig. 7 is a plan view of one portion of an IC on which the TTL circuit of Fig. 6 is formed.

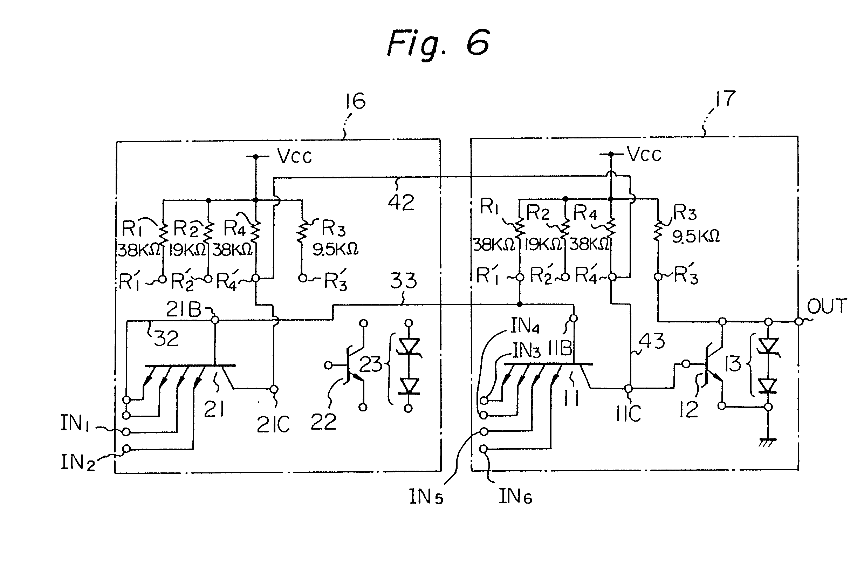

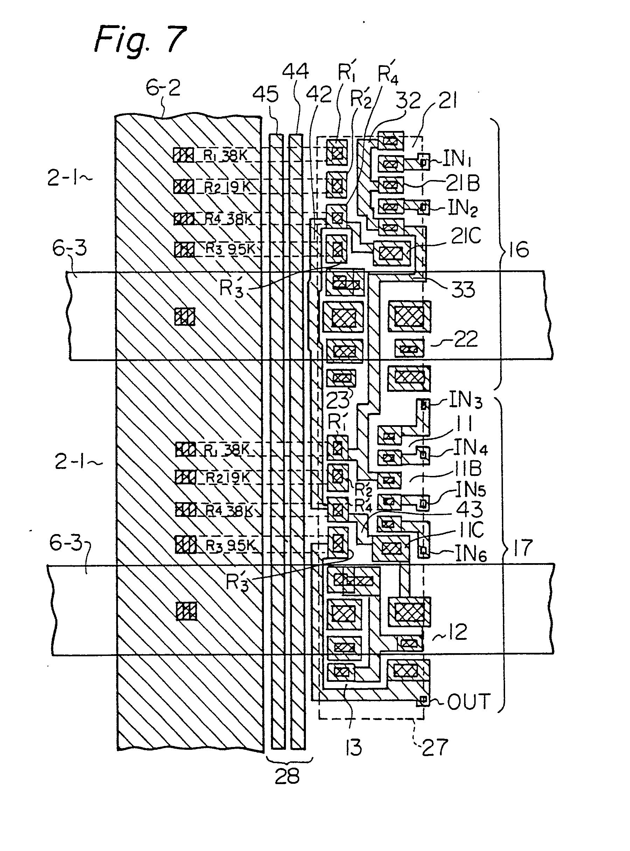

A circuit diagram of a 6-input TTL circuit according to the present invention is shown in Fig. 6. A plan view of one portion of a semiconductor device on which the TTL circuit of Fig. 6 is formed is shown in Fig. 7.

The TTL circuit of Fig. 6 is constructed by two basic cells 16 and 17. In the basic cells of Fig. 6, the resistors $R_1$, $R_2$, $R_3$, and $R_4$ have the resistances of 38 kΩ, 19 kΩ, 9.5 kΩ, and 38 kΩ, respectively. The interconnection of the basic cells 16 and 17 of Fig. 6 is the same as that of Fig. 4 except that the collectors 21C and 11C of the multi-emitter transistors 21 and 11 are connected to the voltage source $V_{cc}$ through two parallel-connected resistors $R_4$ of the basic cells 16 and 17 instead of through one resistor $R_2$ of the basic cell 17. The parallel-connected resistors $R_4$ have the combined resistance of 19 kΩ, and this resistance is the same as that of the resistor $R_2$. In the basic cells of Fig. 6, the resistors $R_1$, $R_2$, $R_3$, and $R_4$ have the resistances of an integer ratio, that is, 4:2:1:4. Accordingly, the combined resistance of the resistors $R_1$, $R_2$, $R_3$, and $R_4$ has an integer ratio with these resistors.

In the semiconductor device of Fig. 7, the TTL circuit of Fig. 6 is constructed by interconnecting the basic cells 16 and 17, as shown in Fig. 7. The collector 21C of the transistor 21 of the basic cell 16 is connected to the electrode $R_4'$ for the resistor $R_4$ of the basic cell 16 through the wiring line 41 formed in the first wiring layer, and the collector 11C of the transistor 11 of the basic cell 17 is connected to the electrode $R_4'$ for the resistor $R_4$ of the basic cell 17 through the wiring line 43 formed in the first wiring layer. The electrodes $R_4'$ for the resistors $R_4$ of the basic cells 16 and 17 are connected to each other through the wiring line 42 formed in the first wiring layer.

Thus, the connection between the collectors 21C and 11C of the transistors 21 and 11 is accomplished by using the wiring lines 41, 42, and 43 formed in the first wiring layer. Accordingly, it is not necessary to use the second wiring layer for the formation of the TTL circuit of Fig. 6. Further, it is not necessary to form through-hole 25 or 29 in the wiring area 28 for the formation of macro-cells because the second wiring layer is not used. When a through-hole is formed in the wiring area, the end of the wiring line corresponding to the through-hole has a relatively large area so as to meet the positioning requirement, as seen in Fig. 5. Thus, the space of the wiring area 28 for the formation of macro-cells is wider in the semiconductor device of Fig. 7 than in the semiconductor device of Fig. 5 due to the absence of a through-hole.

Accordingly, two extra wiring lines 44 and 45 can be drawn in the wiring area 28 in the semiconductor device of Fig. 7 so that the freedom of the wiring layout is increased.

Furthermore, since the current supplied from the voltage source $V_{cc}$ to the collectors 21C and 11C of the transistors 21 and 11 flows through the two resistors $R_4$ of the basic cells 16 and 17, the current distribution between the two basic cells 16 and 17 is equalized and the current margin of the semiconductor device is increased.

As described above, in the semiconductor device according to the present invention, a resistor element having a resistance of R can be constructed by connecting two resistors each having a resistance of 2R or four resistors each having a resistance of 4R in parallel. Accordingly, a resistor element in the TTL circuit having a resistance of R can be obtained in various ways by connecting resistors in basic cells, thereby increasing the freedom of the wiring layout in the macro-cell wiring area 27.

## Claims

1. A semiconductor integrated circuit device comprising a semiconductor substrate; a plurality of voltage source line patterns (6-2) formed on the semiconductor substrate; a plurality of basic cells (16, 17) formed on the semiconductor substrate together with the voltage source line patterns; groups of mutually parallel resistors ($R_1$—$R_4$) formed between the source lines and the basic cells; a plurality of electrodes ($R'_1$—$R'_4$) formed at one end of respective resistors ($R_1$—$R_4$), and connected to a plurality of input transistors (11, 21) formed in the basic cells (16, 17); a plurality of input transistor electrodes (11C, 21C) formed in the basic cells; wiring means (28) formed between the source lines and the basic cells; a macro-cell portion comprising a plurality of the basic cells and having a predetermined logic function, the macro-cell being formed by interconnecting resistors belonging to the respective basic cells and by interconnecting input transistors belonging to the basic cells; characterised in that each of the resistors of a group has a resistance value which is an integral multiple of the value of each lower value resistor in the group; and in that a plurality of wiring patterns (42, 43) is formed on the same layer as the input transistor electrodes and the resistor electrodes, for interconnecting one of the transistor electrodes (11C) and one of the resistor electrodes ($R'_4$) in the first basic cell (17), for interconnecting one of the resistor electrodes ($R'_4$) of the first basic cell (17) and one of the resistor electrodes ($R'_4$) of the second basic cell (16), and for interconnecting one of the resistor electrodes ($R'_4$) and

one of the transistor electrodes (21C) of the second basic cell (16).

2. A semiconductor integrated circuit device, comprising an array of basic cells (16, 17) each including transistors (21, 23; 11, 13) and resistors (R₁—R₄), formed on the surface of a semiconductor substrate and having transistor electrodes and resistor electrodes, respectively, formed in a wiring layer; and at least one macro-cell formed by interconnecting a plurality of basic cells to provide a predetermined logic function; characterised in that a group of resistors (R₁—R₄) in each of the basic cells is so formed that each of the resistors in the group has a value such that the ratio of that value to the value of each lower-value resistor in the group has an integer value; in that resistance means in the logic circuit of the macro-cell is formed by interconnecting at least two resistors belonging to different basic cells of the macro-cell; and in that wiring patterns (42, 43) are formed in the same wiring layer as the transistor electrodes and the resistor electrodes for ineterconnecting the electrodes of said resistors of said different basic cells, and for interconnecting transistor electrodes and resistor electrodes within each basic cell.

**Patentansprüche**

1. Integrierte Halbleiterschaltungsvorrichtung mit einem Halbleitersubstrat; einer Vielzahl von Spannungsquellenleitungsmustern (6-2), die auf dem Halblietersubstrat gebildet sind; einer Vielzahl von Basiszellen (16, 17), die auf dem Halbleitersubstrat zusammen mit den Spannungsquellenleitungsmustern gebildet sind; Gruppen von wechselseitig parallelen Widerständen (R₁—R₄), die zwischen den Verbindungsleitungen und den Baiszellen gebildet sind; einer Vielzahl von Elektroden (R′₁—R′₄), die an einem Ende von entsprechenden Widerständen (R₁—R₄) gebildet sind und mit einer Vielzhal von Eingangstransistoren (11, 21), die in den Basiszellen (16, 17) gebildet sind, verbunden sind; einer Vielzahl von Eingangstransistorelektroden (11C, 21C), die in den Basiszellen gebildet sind, Verdrahtungseinrichtungen (28), die zwischen den Sourceleitungen und den Basiszellen gebildet sind; einem Makrozellenabschnitt, der eine Vielzhal von Basiszellen umfaßt und eine vorbestimmte Logikfunktion hat, wobei die Makrozellen durch Zwischenverbindung von Widerständen gebildet sind, die zu den entsprechenden Basiszellen gehören, und durch Zwischenverbindung von Eingangstransistoren, die zu den Basiszellen gehören, dadurch gekennzeichnet, daß jeder der Widerstände einer Gruppe einen Widerstandswert hat, der ein ganzzahliges Vielfaches des Wertes von jedem niedriger-wertigen Widerstand in der Gruppe ist; und daß eine Vielzahl von Schreibmustern (42, 43) auf derselben Schicht wie die Eingangstransistorelektroden un die Widerstandselektroden gebildet sind, um eine der Transistorelektroden (11C) und eine der Widerstandselektroden (R′₄) in der ersten Basiszelle (17) miteinander zu verbinden, um eine der Widerstandselektroden (R′₄) der ersten Basiszelle (17) und eine der Widerstandselektroden (R′₄) der zweiten Basiszelle (16) miteinander zu verbinden, und um eine der Widerstandselektroden (R′₄) und eine der Widerstandselektroden (21C) der zweiten Basiszelle (16) miteinander zu verbinden.

2. Integrierte Halbleiterschaltungsvorrichtung mit einer Anordnung von Basiszellen (16, 17), die jeweils Transistoren (21, 23; 11, 13) und Widerstände (R₁—R₄) umfassen, die auf der Oberfläche eines Halbleitersubstrats gebildet sind und Transistorelektroden bzw. Widerstandselektroden haben, die in einer Verdrahtungsschicht gebildet sind; und wenigstens einer Makrozelle, die durch Zwischenverbindung einer Vielzahl von Basiszellen gebildet ist, um eine vorbestimmte Logikfunktion vorzusehen; dadurch gekennzeichnet, daß eine Gruppe von Widerständen (R₁—R₄) in jeder der Basiszellen so gebildet ist, daß jeder der Widerstände in der Gruppe einen solchen Wert hat, daß das Verhältnis des Wertes zu dem Wert von jedem niedriger-wertigen Widerstand in der Gruppe ein ganzzahliger Wert ist; daß Widerstandseinrichtungen in der Logikschaltung einer Makrozelle durch Zwischenverbindung von wenigstens zwei Widerständen gebildet sind, die zu verschiedenen Basiszellen der Makrozelle gehören; und daß Verdrahtungsmuster (42, 43) in derselben Verdrahtungsschicht wie die Transistorelektroden und die Widerstandselketroden zur Zwischenverbindung der Elektronden von den genannten Widerständen der genannten verschiedenen Basiszellen gebildet sind, und für die Zwischenverbindung von Transistorelektroden und Widerstandselektroden innerhalb jeder Basiszelle.

**Revendications**

1. Dispositif à circuit intégré à semiconducteur, comprenant: un substrat semiconducteur; plusieurs configurations de lignes de source de tension (6-2) formées sur le substrat semiconducteur; plusieurs cellules de base (16, 17) formées sur le substrat semiconducteur en même temps que les configurations de lignes de source de tension; des groupes de résistances (R₁—R₄) disposées mutuellement en parallèle qui sont formées entre les lignes de source et les cellules de base, plusieurs électrodes (R′₁—R′₄) qui sont formées à une extrémeité de résistances respectives (R₁—R₄) et qui sont connectées à plusieurs transistors d'entrée (11, 21) formés dans les cellules de base (16, 17); plusieurs électrodes de transistors d'entrée (11C, 21C) qui sont formées dans les cellules de base; des moyens de câblage (28) qui sont formés entre les lignes de source et les cellules de base; une partie macrocellule comprenant plusieurs cellules de base et possédant une fonction logique prédéterminée, la macrocellule étant formée par interconnexion de résistances appartenant aux cellules de base respectives et par interconnexion de transistors d'entrée appartenant aux cellules de base; caractérisé en ce que chacune des résistances d'un groupe possède une valeur de résistance qui est un multiple entier de la valeur de chaque résistance de valeur inférieure dugroupe; et en ce que plusieurs configuration de câblage (42, 43) sont formées sur la même couche que les électrodes de transistors d'entrée et les électrodes de résistances, afin d'interconnecter l'une des électrodes de transistors (11C) et l'une des électrodes de résistances (R'$_4$) de la première cellule de base (17), afin d'interconnecter une des électrodes de résistances (R'$_4$) de la première cellule de base (17) et l'une des électrodes de résistances (T'$_4$) de la deuxième cellule de base (16), et afin d'interconnecter une des électrodes de résistances (R'$_4$) et une des électrodes de transistors (21C) de la deuxième cellule de base (16).

2. Dispositif à circuit intégré à semiconducteur, comprenant: un ensemble de cellules de base (16, 17) comportant chacune des transistors (21, 23; 11, 13) et des résistances (R$_1$—R$_4$) qui sont formés à la surface d'un substrat semiconducteur et qui possèdent respectivement des électrodes de transistors et des électrodes de résistances, formées dans une couche de câblage; et au moins une macrocellule formée par interconnexion de plusieurs cellules de base de manière à produire une fonction logique prédéterminée; caractérisé en ce qu'un groupe de résistances (R$_1$—R$_4$) de chacune des cellules de base est ainsi formé que chacune des résistances du groupe possède une valeur telle que le rapport de cette valeur à la valeur de chaque résistance de valeur inférieure du groupe a une valeur entière; en ce que des moyens de résistance du circuit logique de la macrocellule sont formés par interconnexion d'au moins deux résistances appartenant à des cellules de base différentes de la macrocellule; et en ce que des configurations de câblage (42, 43) sont formées dans la même couche de câblage que les électrodes de transistors et les électrodes de résistances afin d'interconnecter les électrodes desdites résistances desdites différentes cellules de base et afin d'interconnecter des électrodes de transistors et des électrodes de résistances à l'intérieur de chaque cellule de base.

## Fig. 1A



Fig. IB

0 074 804

2

# *Fig. 2A*

16

17

Vcc

R₁ R₂ R₄ R₃

11

12 13

Vcc

R₁ R₂ R₄ R₃

11

12 13

# Fig. 2 B

0 074 804

0 074 804

*Fig. 3*

5

*Fig. 4*

# Fig. 5

*Fig. 6*

0 074 804

# Fig. 7